# DEMANDE DE BREVET EUROPEEN

(11) **EP 1 710 416 A1**
(43) Date de publication de la demande: **11.10.2006**
(21) Numéro de dépôt: 06290479.2
(22) Date de dépôt: 24.03.2006
(51) Int. Cl.: F02B 77/02, C23C 16/27

(54) **Revêtement de protection pour un composant d'un moteur, balayé par des gaz d'échappement**

(30) Priorité: 05.04.2005 FR 0503390
(71) Demandeur: Institut Français du Pétrole, 92852 Rueil Malmaison Cédex (FR)
(72) Inventeur: Lynch, John, 92500 Rueil Malmaison (FR)

(57) **Abrégé**

La présente invention concerne un composant balayé par des gaz d'échappement, notamment composant d'un moteur à combustion interne (12) et/ou d'au moins un circuit de circulation de gaz d'échappement (14, 16, 18, 20) faisant partie d'un groupe moteur (10).

Selon l'invention, les surfaces en contact avec les gaz d'échappement d'au moins un composant comportent un revêtement de protection comprenant au moins une partie de carbone amorphe de structure locale proche du diamant.

## Description

La présente invention se rapporte à un composant qui est en contact avec des gaz d'échappement, notamment composant de groupe moteur avec un moteur à combustion interne avec au moins un circuit de circulation des gaz d'échappement.

De tels moteurs fonctionnent généralement avec une telle recirculation en vue d'améliorer la réduction des émissions de polluants et plus particulièrement des émissions d'oxydes d'azote (NOx).

Comme cela est connu, l'utilisation de la recirculation d'une partie des gaz d'échappement à l'admission du moteur pour réduire les émissions de NOx est devenue un processus courant. En effet, les gaz d'échappement sont utilisés dans ce but, car ce sont des gaz pauvres en oxygène qui résultent de la combustion des cycles précédents de fonctionnement du moteur. Ainsi, l'introduction de tels gaz d'échappement dans les cylindres en phase d'admission a pour effet de diminuer la quantité d'air frais pouvant se mélanger avec le carburant. Ceci permet d'abaisser la température de combustion du mélange carburé et par conséquent de réduire la production de NOx résultant de cette combustion.

Généralement, cette recirculation de gaz d'échappement est réalisée grâce à un circuit, dénommé circuit EGR (Exhaust Gas Recirculation) comprenant un conduit reliant le collecteur d'échappement du moteur à son collecteur d'admission. Ce conduit porte une vanne, dite vanne EGR, qui permet de contrôler le flux de gaz qui y circule entre une position de pleine fermeture et une position de pleine ouverture de la vanne.

Avantageusement, il est prévu de placer un échangeur-refroidisseur de gaz d'échappement recirculé, dénommé EGR Cooler, qui a pour effet de contrôler la température des gaz d'échappement avant leur introduction dans le collecteur d'admission. Ce refroidisseur est constitué de tubes (ou de tubes ailettés) à l'intérieur desquels circule un fluide de refroidissement et qui sont balayés par les gaz d'échappement de manière à échanger les calories de ces gaz avec le fluide de refroidissement.

Le moteur peut être également un moteur de type à air suralimenté qui comprend un dispositif de suralimentation, tel qu'un turbocompresseur, qui comprime l'air ambiant qu'il reçoit et l'envoie, à l'état comprimé, à l'admission du moteur. Ce turbocompresseur, qui est habituellement placé dans la ligne d'échappement, comporte une turbine qui est entraînée en rotation par les gaz d'échappement issus du moteur et circulant dans cette ligne d'échappement. Cette turbine est liée en rotation avec un compresseur de manière à ce que la rotation de ce dernier comprime l'air ambiant avant son envoi dans l'admission du moteur.

Ce dispositif de suralimentation comprend également un circuit de décharge des gaz d'échappement qui permet de gérer la quantité de gaz d'échappement traversant la turbine. Pour ce faire, il est prévu un conduit de contournement qui prend naissance sur la ligne d'échappement en amont de la turbine et aboutit en aval de cette turbine sur cette ligne d'échappement. Une vanne de décharge, plus connue sous le terme anglais de "waste gate", est disposée en amont de la turbine à l'intersection du conduit de contournement avec la ligne d'échappement. La vanne peut atteindre une multiplicité de positions intermédiaires entre une position de pleine fermeture où elle obture le conduit de contournement pour que la totalité des gaz d'échappement traverse la turbine et une position de pleine ouverture où elle libère l'entrée de ce conduit de contournement. Ainsi, cette vanne permet de contrôler la quantité de gaz d'échappement à l'entrée de la turbine et, par conséquent, la pression de l'air sortant du compresseur.

Ces dispositifs, bien que donnant satisfaction, présentent néanmoins des inconvénients non négligeables.

En effet, les surfaces froides de grande dimension d'une grande partie des composants du moteur, comme celles de l'échangeur-refroidisseur du circuit EGR en particulier, sont en contact avec les gaz d'échappement chauds contenant des hydrocarbures imbrûlés, des oxydes de sulfure, des oxydes d'azote et des particules de suies. Les particules de suies peuvent s'accrocher à ces surfaces alors que les produits soufrés et azotés peuvent former des acides corrosifs lors de leurs condensations sur ces surfaces. Il en résulte une possibilité d'encrassement et/ou de corrosion de ces composants en contact avec les gaz d'échappement.

Ainsi, l'encrassement des surfaces extérieures des tubes ou des tubes ailetés de l'échangeur-refroidisseur réduit sa capacité d'échange avec le fluide de refroidissement, provoquant alors une dégradation de ses performances. De plus, la corrosion des pièces constitutives de cet échangeur-refroidisseur par les acides réduit la durée de vie du circuit EGR.

Cet encrassement peut aussi entraîner une diminution des capacités fonctionnelles de certains composants du moteur, comme les soupapes ou les vannes EGR et de décharge dont l'étanchéité totale dans les positions de fermeture n'est plus assurée, ou comme les injecteurs qui peuvent avoir certains de leurs trous d'injection partiellement obturés par les particules de suie.

De plus, les conduits aussi bien du circuit d'EGR que ceux du circuit de décharge et ceux de la ligne d'échappement peuvent faire l'objet d'un encrassement par les particules et/ou d'une corrosion par les produits soufrés et azotés.

La présente invention se propose de remédier aux inconvénients ci-dessus grâce à des composants qui ne soient pas sujets à l'encrassement par les gaz d'échappement.

A cet effet, l'invention concerne un composant balayé par des gaz d'échappement, notamment composant d'un moteur à combustion interne et/ou d'au moins un circuit de circulation de gaz d'échappement faisant partie d'un groupe moteur, caractérisé en ce que les surfaces en contact avec les gaz d'échappement d'au moins un composant comportent un revêtement de protection comprenant au moins une partie de carbone amorphe de structure locale proche du diamant.

L'épaisseur du revêtement peut être typiquement de quelques microns jusqu'à environ 0,5 mm.

De manière avantageuse, le revêtement peut comprendre une fraction d'hydrogène.

Préférentiellement, l'hydrogène peut être mélangé à au moins un hétéroélement.

L'hétéroélement peut être choisi parmi le silicium, le fluor, l'oxygène, l'azote.

Le revêtement peut comprendre une fraction d'hydrogène au plus de 80%.

Le revêtement peut comprendre une fraction de l'hétéroélément au plus de 20%.

L'invention concerne également un procédé pour revêtir des surfaces en contact avec les gaz d'échappements d'au moins une partie des composants selon lequel on peut déposer le revêtement de protection comprenant au moins une partie de carbone amorphe de structure locale proche du diamant par décomposition par plasma de gaz hydrocarbures légers.

On peut également déposer le revêtement de protection comprenant au moins une partie de carbone amorphe de structure locale proche du diamant par ablation d'une cible de carbone.

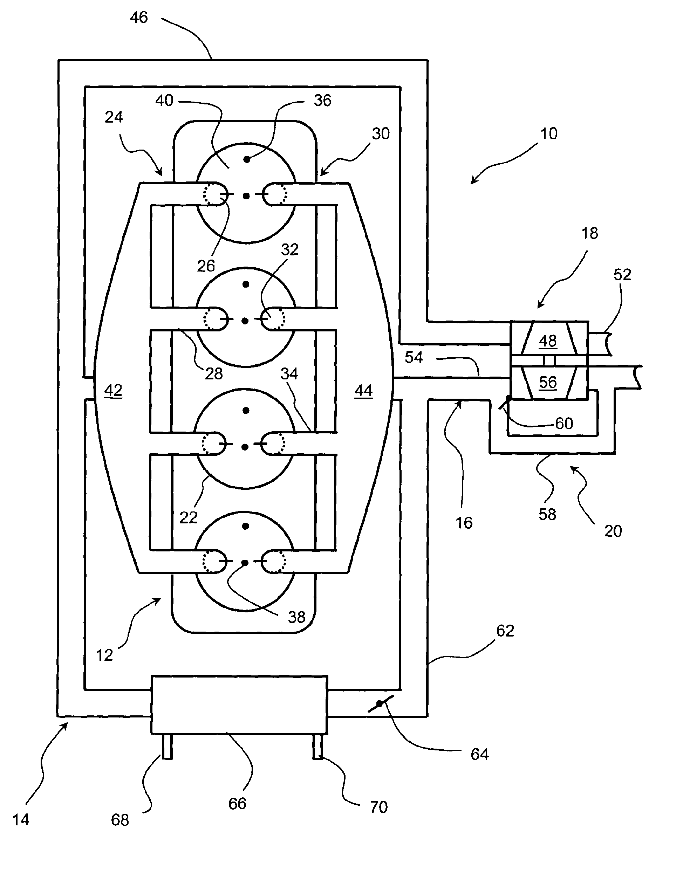

Les autres caractéristiques et avantages de l'invention apparaîtront mieux à la lecture de la description qui va suivre, donnée uniquement à titre illustratif et nullement limitatif, en se référant à la figure unique qui montre un groupe moteur selon l'invention.

Sur cette figure le groupe moteur 10 comprend un moteur 12 à combustion interne associé à au moins un circuit de circulation des gaz d'échappement avec un circuit de recirculation des gaz d'échappement 14 ou circuit EGR, une ligne d'échappement 16 sur laquelle est placé un turbocompresseur 18 avec son circuit de décharge 20.

Le moteur 12 comprend au moins un cylindre 22 avec au moins un moyen d'admission 24 avec une soupape d'admission 26 et une tubulure d'admission 28 et au moins un moyen d'échappement 30 avec une soupape d'échappement 32 et une tubulure d'échappement 34. Dans le cas où le moteur à combustion interne est un moteur à injection directe à allumage contrôlé, chaque cylindre est pourvu d'un injecteur de carburant 36 dans le cylindre et une bougie d'allumage 38 du mélange carburé présent dans ce cylindre. Ce cylindre comprend un piston (non référencé) qui coulisse de manière alternative rectiligne dans ce cylindre en délimitant une chambre de combustion 40 entre le haut du piston et généralement la culasse du moteur (non représentée) dans laquelle sont placés les moyens d'admission et d'échappement. Les tubulures 28 des moyens d'admission sont raccordées à un collecteur d'admission 42 alors que les tubulures des moyens d'échappement 30 aboutissent à un collecteur d'échappement 44.

Le collecteur d'admission 42 est relié par une conduite 46 à la sortie d'un étage de compression 48 du turbocompresseur 18 qui admet de l'air extérieur par une conduite 52. Le collecteur d'échappement 44 est raccordé à la ligne d'échappement 16 qui comprend généralement une conduite d'échappement 54 servant à évacuer dans l'atmosphère les gaz d'échappement du moteur. Sur cette conduite d'échappement est placée l'entrée de l'étage d'entraînement 56 du turbocompresseur 18. Cet étage comporte, de manière connue, une turbine qui est entraînée en rotation par les gaz d'échappement qui rejoignent ensuite la conduite d'échappement 54 après leur traversée de la turbine.

Le circuit de décharge 20 de ce turbocompresseur comprend un conduit de contournement 58 qui prend naissance en amont de l'étage d'entraînement 56 sur la conduite d'échappement 54 et contourne cet étage pour aboutir sur la conduite d'échappement en aval de cet étage d'entraînement. Une vanne de décharge 60 (ou "waste gate"), qui contrôle le débit de gaz d'échappement traversant l'étage 56, est placée à l'intersection entre le conduit de contournement 58 et la conduite 54.

Le circuit de recirculation 14 comprend une conduite de recirculation 62 de gaz d'échappement qui débute à la conduite d'échappement 54 et qui aboutit à l'entrée du collecteur d'admission 42. Ce conduit de recirculation porte une vanne 64, dite vanne EGR, qui permet de régler la quantité de gaz d'échappement réintroduits dans le collecteur 42. De plus, ce conduit porte un échangeur-refroidisseur 66 qui est traversé par les gaz d'échappement et qui est ainsi utilisé pour contrôler la température de ces gaz à l'entrée du collecteur d'admission. Cet échangeur est parcouru par un fluide de refroidissement, généralement le fluide de refroidissement du moteur, entre une entrée 68 et une sortie 70.

Ainsi, une majorité des composants constitutifs du groupe moteur 10 est parcourue par des gaz d'échappement, soit lors de la recirculation de ces gaz, soit pour l'entraînement du turbocompresseur ou pour l'évacuation de ces gaz.

Plus précisément dans l'exemple décrit, les gaz d'échappement recirculés balayent les chambres de combustion 40, les moyens d'admission 24 et d'échappement avec leurs soupapes et leurs tubulures, les collecteurs d'admission 42 et d'échappement 44, la conduite d'échappement 54, l'étage d'entraînement 56 du turbocompresseur avec sa turbine, le circuit de décharge 20 avec son conduit de contournement et sa vanne de décharge, et le circuit EGR 14 avec le conduit de recirculation, l'échangeur-refroidisseur et la vanne EGR.

Pour éviter que ces composants ne soient sujets à l'encrassement et/ou la corrosion par les gaz d'échappement, il est prévu que les surfaces balayées par ces gaz d'échappement de tout ou partie de ces composants soient revêtues d'une protection, avantageusement sous forme d'un film, comprenant un matériau en carbone amorphe de structure locale proche du diamant, plus connu sous le vocable DLC (en anglais "Diamond Like Carbon").

Dans ce type de matériau, une fraction des atomes de carbone présente des liaisons atomiques en un arrangement tétraédrique (des liaisons dites de nature sp³), caractéristique de la structure locale du diamant. La fraction de liaisons sp³, généralement dans la gamme de 0,3 à 0,9, est typiquement supérieure à 0,5. Ces formes de carbone amorphe proches du diamant possèdent une dureté supérieure à 10 GPa, pouvant aller jusqu'à 130 GPa, et un faible coefficient de frottement (inférieure à 0,12 pour une fraction de liaisons sp³ supérieure à 0,75).

Le DLC possède des propriétés avantageuses notamment pour son utilisation dans des systèmes d'échangeurs de chaleur et en particulier pour l'échangeur-refroidisseur 66 du circuit EGR. Sa conductivité thermique est élevée (700 W m⁻¹ K⁻¹, comparable au cuivre : 400 et supérieure à l'aluminium : 235). Il possède également une bonne résistance à la corrosion chimique.

L'utilisation de DLC réduit également de manière significative l'encrassement des surfaces qu'il protège en limitant fortement le dépôt des particules de suies et des molécules d'hydrocarbures imbrûlées.

Le dépôt du DLC se fera de préférence par l'utilisation d'un procédé de décomposition par plasma de gaz hydrocarbures légers tels que l'acétylène, l'éthylène, le méthane et autres. Avantageusement, le gaz hydrocarbure peut être mélangé à de l'hydrogène ou à un gaz rare, tel que l'argon.

Le dépôt peut aussi se faire par ablation d'une cible de carbone, comme cela est décrit dans "Journal of Materials Science" en date du 15 mai 2004 selon la publication "Synthesis of HDLC films from solid carbon" de R. L. Mills, J. Sankar, P. Ray, A. Voigt, J. He et B. Dhandapani.

Avantageusement, l'épaisseur du dépôt est typiquement de quelques microns (2 à 4 microns) à environ 0,5 mm.

Le revêtement DLC peut également inclure une fraction d'hydrogène et d'autres éléments, comme par exemple F, Si, O, N. Ces éléments sont introduits par l'addition de gaz réactifs (par exemple respectivement C₂F₂, Si(CH₃)₄, O₂ or N₂) à l'hydrocarbure servant à former le dépôt.

Grâce à cela, le procédé est bien adapté aux dépôts sur des surfaces complexes métalliques.

L'inclusion d'hétéroéléments permet de moduler les propriétés en fonction des conditions d'opération prévues. En effet, une approche de l'élaboration de dépôts anti-encrassement est de rendre la surface du matériau répulsive, ou moins attractive, aux composés responsables de l'encrassement. Par exemple, les dépôts sans hydrogène ont moins d'interaction avec les composés oxygénés et seront donc favorables à une réduction d'encrassement par ces composants. Au contraire, les dépôts avec hydrogène ont moins d'interaction avec les hydrocarbures.

De manière avantageuse, la gamme du contenu en hydrogène peut être de 0% à 80% et celle du silicium, du fluor, de l'oxygène ou de l'azote peut varier de 0% à 20%.

La présente invention n'est pas limitée à l'exemple décrit mais englobe toutes variantes ou équivalent.

Notamment, il a été fait mention jusqu'à maintenant de composants d'un groupe moteur balayé par des gaz d'échappement provenant d'un moteur à combustion interne. Ce composant peut aussi faire partie de toute autre unité comme une turbine à gaz dont les gaz d'échappement (ou fumées) balayent la turbine de détente et éventuellement un échangeur de chaleur dans le cas de turbine à cogénération.

## Revendications

1. Composant balayé par des gaz d'échappement, notamment composant d'un moteur à combustion interne (12) et d'au moins un circuit de circulation de gaz d'échappement (14, 16, 18, 20) faisant partie d'un groupe moteur (10), **caractérisé en ce que** les surfaces en contact avec les gaz d'échappement d'au moins un composant comportent un revêtement de protection comprenant au moins une partie de carbone amorphe de structure locale proche du diamant.

2. Composant balayé par des gaz d'échappement selon la revendication 1, **caractérisé en ce que** l'épaisseur du revêtement est typiquement de quelques microns jusqu'à environ 0,5 mm.

3. Composant balayé par des gaz d'échappement selon la revendication 1 ou 2, **caractérisé en ce que** le revêtement comprend une fraction d'hydrogène.

4. Composant balayé par des gaz d'échappement selon la revendication 3, **caractérisé en ce que** l'hydrogène est mélangé à au moins un hétéroélement.

5. Composant balayé par des gaz d'échappement selon la revendication 4, **caractérisé en ce que** l'hétéroélement est choisi parmi le silicium, le fluor, l'oxygène, l'azote.

6. Composant balayé par des gaz d'échappement selon l'une des revendications précédentes, **caractérisé en ce que** le revêtement comprend une fraction d'hydrogène au plus de 80%.

7. Composant balayé par des gaz d'échappement selon la revendication 4, **caractérisé en ce que** le revêtement comprend une fraction de l'hétéroélément au plus de 20%.

8. Procédé pour revêtir des surfaces en contact avec les gaz d'échappement d'au moins une partie des composants selon l'une des revendications 1 à 7, **caractérisé en ce que** l'on dépose le revêtement de protection comprenant au moins une partie de carbone amorphe de structure locale proche du diamant par décomposition par plasma de gaz hydrocarbures légers.

9. Procédé pour revêtir des surfaces en contact avec les gaz d'échappement d'au moins une partie des composants selon l'une des revendications 1 à 7, **caractérisé en ce que** l'on dépose le revêtement de protection comprenant au moins une partie de carbone amorphe de structure locale proche du diamant par ablation d'une cible de carbone.

10. Groupe moteur (10) comportant un moteur à combustion interne (12) et au moins un circuit de circulation de gaz d'échappement permettant la recirculation des gaz d'échappement (14) dans le moteur, **caractérisé en ce qu'**il comprend au moins un composant balayé par des gaz d'échappement selon l'une des revendications 1 à 7.

11. Groupe moteur (10) comportant un moteur à combustion interne (12) et au moins un circuit de circulation de gaz d'échappement pour la commande d'un dispositif de suralimentation de l'air d'admission (18, 20), **caractérisé en ce qu'**il comporte au moins un composant balayé par des gaz d'échappement selon l'une des revendications 1 à 7.

12. Groupe moteur (10) comportant un moteur à combustion interne (12) et au moins une ligne d'échappement (16) pour l'évacuation des gaz brûlés, **caractérisé en ce qu'**il comporte au moins un composant balayé par des gaz d'échappement selon l'une des revendications 1 à 7.
